Europäisches Patentamt

European Patent Office

Office européen des brevets

(19)

(11) Publication number: **0 165 561 B1**

# EUROPEAN PATENT SPECIFICATION

(12)

(45) Date of publication of patent specification: **29.05.91**  (51) Int. Cl.5: **H05K 13/00**

(21) Application number: **85107319.7**

(22) Date of filing: **13.06.85**

(54) Device for the treatment of flat plates.

(30) Priority: **16.06.84 DE 3422415**

(43) Date of publication of application:
**27.12.85 Bulletin 85/52**

(45) Publication of the grant of the patent:
**29.05.91 Bulletin 91/22**

(84) Designated Contracting States:
**BE CH FR GB IT LI NL**

(56) References cited:
**EP-A- 0 135 117**
**DE-A- 2 602 622**
**FR-A- 2 495 121**
**US-A- 3 625 377**

(73) Proprietor: **E.I. DU PONT DE NEMOURS AND COMPANY**
**1007 Market Street**
**Wilmington Delaware 19898(US)**

(72) Inventor: **Waas, Frank Ferdinand Georg Michael**
**Im Birkengrund 9**
**W-6380 Bad Homburg v.d.H.(DE)**

(74) Representative: **Werner, Hans-Karsten, Dr. et al**
**Deichmannhaus am Hauptbahnhof**
**W-5000 Köln 1(DE)**

## Description

### BACKGROUND OF THE INVENTION

This invention relates to treating devices for flat plates and more particularly to a device for holding and transporting a printed circuit board through a treating apparatus.

In the production of printed circuits a printed circuit board comprising a fiberglass core covered with a sheet of copper, over which is laminated a photosensitive layer, is imagewise exposed. Following exposure, the unexposed areas are removed and the underlying metal sheet uncovered. The uncovered metal areas can then be either etched or further metallized depending on the end result desired. Subsequently, the remaining photosensitive material which up to this point has been serving as a protective mask, is removed. Similar process steps may be employed when the printed circuit board is coated with a solder stop mask before the soldering process.

The individual process steps are usually separated by a holding or waiting period during which the printed circuit board may be held for an intermediate treatment in a controlled environment, such as a drying oven, etc.

It is desirable, therefore, to develop a device which will allow such intermediate treating of a flat printed circuit board without interrupting a continuous process and without requiring excessively long transport belts. Desirably such device will permit to hold the individual members for intermediate treatment in a limited confined space without contacting each other.

It is further desirable that such a holding and transporting device may form a part of a plate transport system, or of a continuous treatment or production process.

### SUMMARY OF THE INVENTION

The present invention is directed to a device for the treatment of planar members that are subjected to the same treatment during a number of cycles, comprising a vertical conveyer with support elements on which several members can be supported one above the other with a space between them on both sides; by an upper and a lower support plane situated one above the other laterally next to the vertical conveyer a horizontal conveyer situated in the region of the support planes that is capable of traveling towards the vertical conveyer and returning in every cycle, a first carrier that during the travel movement transports a member from a one support plane which is an entry support plane onto support elements of the vertical conveyer, and a second carrier that during the return movement transports a member from the support elements of the vertical conveyor onto another support plane which is an exit support plane.

### BRIEF DESCRIPTION OF THE DRAWINGS

The invention may be more fully understood from the following detailed description, thereof, taken in connection with accompanying drawings which form a part of this application and in which:

Fig. 1 is a schematic side view of a holding and treating device in accordance with this invention,

Fig. 2 shows a schematic front view elevation of the vertical conveyer in the device of Fig. 1,

Fig. 3 shows a schematic perspective view of the upright supports and the pins extending therefrom in a conveyer of the type shown in Fig. 2,

Fig. 4 is a schematic representation of a top view of a conveyer of the type shown in Fig. 2,

Fig. 5 shows a partial top view of the conveyer, wherein the supports have been rotated by a 90° angle,

Fig. 6 shows a schematic side view of a gripper mechanism employed to remove a board from the conveyor,

Fig. 7 shows a schematic side view of the arrangement employed to remove the gripper from the board,

Fig. 8 shows a side view of a modified gripper, and

Fig. 9 shows a schematic front view of a modified conveyer.

### DETAILED DESCRIPTION OF THE INVENTION

The instant invention relates to a holding and transporting device for planar members comprising:
a base,
a plurality of elongated upright supports defining an enclosure, each support pivotally mounted around an axis perpendicular to the base extending through said supports,
each support having at least two orthogonal pins extending therefrom perpendicular to the axis of the support,
each of said pins located at a point along said axis different than the other,
the pins on the plurality of the upright supports cooperating to define at least a first and a second parallel distinct horizontal planes, and
means to rotate the upright supports through an angle from a first position where a first plurality of pins defining the first horizontal plane extend within said enclosure, to a second position where a second plurality of pins defining the second horizontal plane extend within said enclosure, said first plurality of pins no longer extending within said enclosure.

Rotation of the upright supports through this angle results in a flat plate supported by the plurality of pins on one level to be released and drop to a second level defined by the second plurality of pins brought into position within the enclosure as a result of the rotation of the upright supports. The angle of rotation is about 90°.

Instead of only two pins on each upright support, a multitude of pins may be employed to define a multitude of parallel and distinct planes whereby a number of flat plates may be supported on alternate planes. As the upright supports are rotated alternatively between a first and a second position, the members are dropped from one set of parallel planes defined by one set of pins to a second set of parallel planes defined by a second set of pins.

Means may also be available to introduce a flat plate at the top horizontal plane from a supply of plates located adjacent the present device and means may be available to grasp and remove a flat plate from the bottom plane and to release it onto an outside transport device, for further treatment.

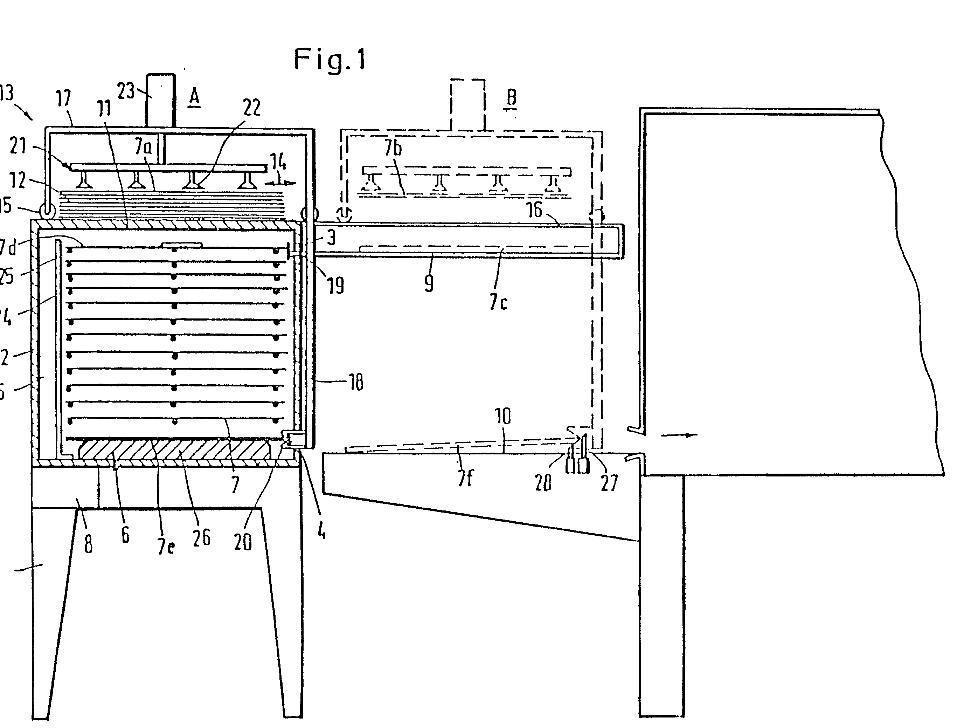

Throughout the following detailed description similar reference numerals refer to similar reference elements in all figures of the drawing. With reference to the preferred embodiment as shown in Fig. 1 there is shown a housing 2 that has an upper entry slot 3 and a lower exit slot 4, standing on a table 1. Within the interior of said housing there is a vertical conveyor 6 in accordance with the present invention for holding and transporting a number of flat plates which in this instance are a number of printed circuit boards. The housing may comprise a dryer chamber 5 employing hot air injected therein by means of a blower 8. The details of the blower are not shown in this figure, such blower being conventional and well known in the art. An upper or entry support tray 9 is situated next to the entry slot 3. A lower or exit tray 10 is placed next to exit slot 4. On the housing 2 above the conveyor 6, there is a storage compartment 11 for a stack 12 of printed circuit boards.

A horizontal transport 13 is used to bring plates out of compartment 11 and into the dryer chamber 5. The transport 13 moves in the direction of arrow 14 on a set of rollers 15 on a guide 16 from a left hand position A shown in solid lines to a right hand position B shown in phantom lines. Transport 13 includes a frame 17 with an arm 18 extending downwardly. Mounted on this arm at the level of entry slot 3 is a first plate carrier 19 which serves to bring a plate into the conveyor 6. At the end of arm 18 near the level of exit slot 4 is placed a plate gripper 20 which serves to grip and remove a plate from conveyor 6. A second plate carrier 21 is mounted near the top of transport 13. Carrier 21 comprises a supporting plate on which are mounted several suction cups 22 which can be lowered onto the stack 12 by means of a driving cylinder 23 attached to the top of the transport 13.

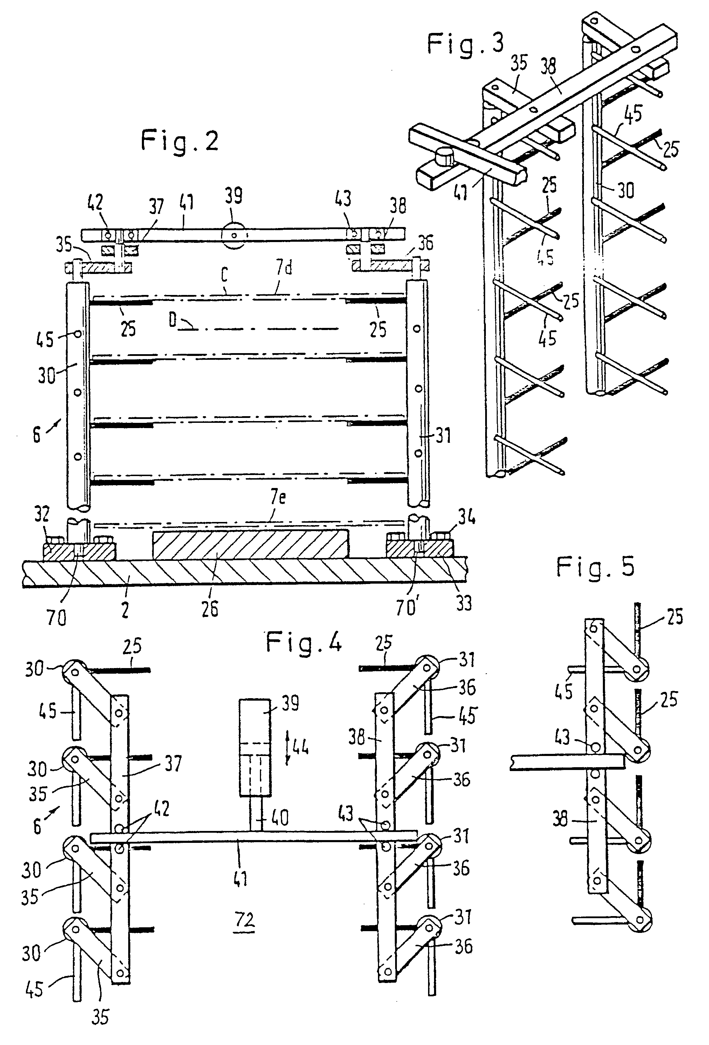

Referring now to Figs. 2, 3, 4 and 5 a number of upright supports 30 and 31 are mounted on the base of housing 2. The supports are mounted using mounting blocks 32 and 33 which are adjustably located on housing 2 by means of screws 34. Thus the distance between uprights 30 and 31 may be varied depending on the size of the plate to be supported thereinbetween.

Mounted on uprights 30 and 31 are a number of pins 25 and 45 generally placed at 90° to each other at different points along an axis running through the center of upright supports 30 and 31. The position of pins 25 and 45 is such that the pins are not in the same plane. Upright supports 30 and 31 are pivotally mounted around the axis extending along the long dimension of the support, on mounting blocks 32 and 34 using pins 70 and 70'. Upright supports 30 and 31 are fitted on the upper end with pivoting levers 35 and 36. Pivoting levers 35 are all pivotally connected to a connecting rod 37 and pivoting levers 36 are all pivotally connected to connecting rod 38. A set of roller bearings 42 and 43 are placed on connecting rods 37 and 38 respectively. A cam rod 41 spans the space between connecting rods 37 and 38 and is placed so that bearings 42 and 43 ride on rod 47. A pneumatic drive 39 is mounted on the housing 2. A push rod 40 extending from the drive is connected to cam rod 41. The pneumatic drive can move rod 40 in the direction of arrow 44 on command.

The plurality of upright supports 30 and 31 define an enclosure 72. The initial orientation of the upright supports 30 and 31 is such that the plurality of pins 25 extend into the enclosure while the plurality of pins 45 do not.

A bottom plate 26 is located in the enclosure 72 on the lower portion of housing 2. Plate 26 extends above mounting blocks 32 and 34 and its top surface is on the level of exit slot 4.

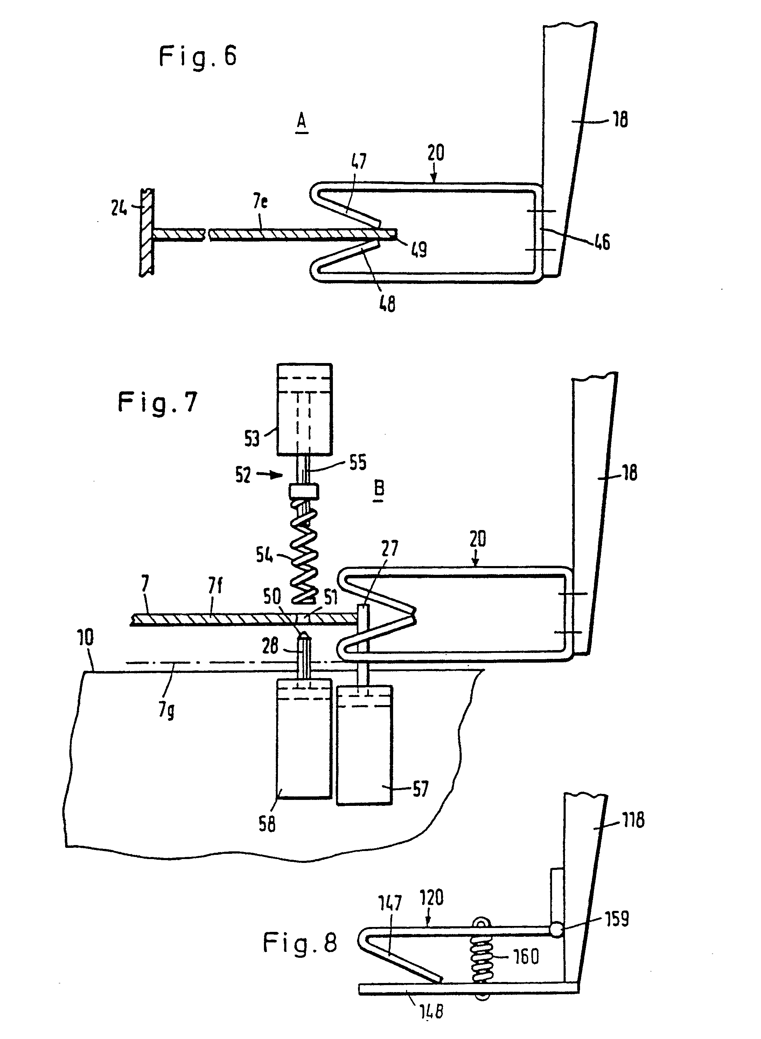

In Fig. 6 there is shown the details of gripper 20. This gripper which is attached to the bottom end of transport arm 18 comprises a spring clip constructed by forming a single piece of a flat metal strap. It's back flange 46 is attached to arm 18. The front end forms two clamping arms 47 and 48 bent back diagonally to provide a pair of gripping jaws.

Figure 8 shows a modified alternate embodiment for a gripper 120. One clamping arm 148 is used in this instance connected rigidly to the end of transport arm 118. A second clamping arm 147 made by bending a strap of metal which is joined to arm 118. using a hinge 159. An adjustable spring 160 permits to select the clamping force between the two arms.

Figure 7 shows the details of a device employed near the exit slot 4 which permits the disengagement of a flat plate from the jaws of gripper 20. This device may be attached either onto the housing 2 or as shown in Fig. 1 form an integral part of the receiving device for receiving a printed circuit board released from the device subject of this invention. Referring back to Fig. 7, the gripper 20 is shown in its right hand position B. In that position, the gripper has moved past the release device stop 27. This device which may comprise a pin extending in the path of a flat plate held in the jaws of gripper 20 provides a positive stop to the advance of the plate. Just ahead of pin 27 is located a second pin 28 pneumatically driven through pneumatic cylinder 58. Pin 28 terminates in a pointed tip 50. Adjacent to pin 28 and coaxially spaced therefrom, is placed a second pneumatic cylinder 53 at a distance from tip 50 sufficient to permit passage of a flat plate. This second pneumatic cylinder terminates to a spring 54 connected to the cylinder through driving rod 55.

In operation a number of flat plates to be treated may be stored on housing 2 under transport 13. The stack of plates may comprise a number of printed circuit boards which must be dried prior to further treatment. Suction cups 22 are lowered to grip the uppermost plate 7A of the stack 12 from position A and move it towards position 7B shown in phantom lines in Fig. 1. Once the transport 13 reaches position B the suction is released and the plate falls into position 7C on support tray 9 next to entry slot 3. Transport 13 now returns to position A. During this return operation, the flat plate is pushed by first plate carrier 19 onto the top level of vertical conveyor 6 supported onto the first topmost set of pins 25 until it comes to rest against a stop 24 in position 7D. The plate is now wholly supported on pins 25. Once the plate is on pins 25, the pneumatic drive 39 is actuated pushing rod 40. As a result of moving rod 40 in one direction, connecting rods 37 and 38 are driven in the same direction as rod 40. Pivoting levers 35 and 36 follow the movement of rods 37 and 38 pivoting upright supports 30 and 31. As a result, the plurality of pins 25 is swung horizontally around an arc which moves them outside of the enclosure 72. At the same time, the plurality of pins 45 are swung inwardly into the enclosure 72. As a result of this movement, the plate is no longer supported by pins 25 and falls through the action of gravity towards the bottom of housing 2. However, pins 45 located below pins 25 have now entered into the enclosure and interrupt the downward movement of the plate supporting it at a level below the original level. This action is repeated a number of times alternately bringing pins 45 and 25 in and out of the enclosure and slowly moving a plate from the upper portion of the housing towards the bottom of the housing. Between each movement of the pins the transport 13 may be actuated to bring a fresh plate to the top level of the housing. When a plate reaches the lowermost (7E) level of the housing it is gripped by gripper 20 which enters the lowermost portion of the housing through slot 4. The edge of the plate is inserted in the jaws of gripper 20. When transport 13 moves away from the housing, the plate is carried with it outside of the housing. As the plate advances to position 7F the forward edge of the plate abutts against pin 27 whereby the movement of the plate is stopped. However the movement of gripper 20 continues, thus releasing the plate from the jaws of the gripper. At that point if desirable, the pneumatic drive 53 is actuated lowering the spring 54 and driving the plate against pin 28. A predrilled hole 51 in the plate receives pin 28 and aligns the plat with respect to a fixed reference in the takeup device. The plate may now be removed for further treatment as desirably.

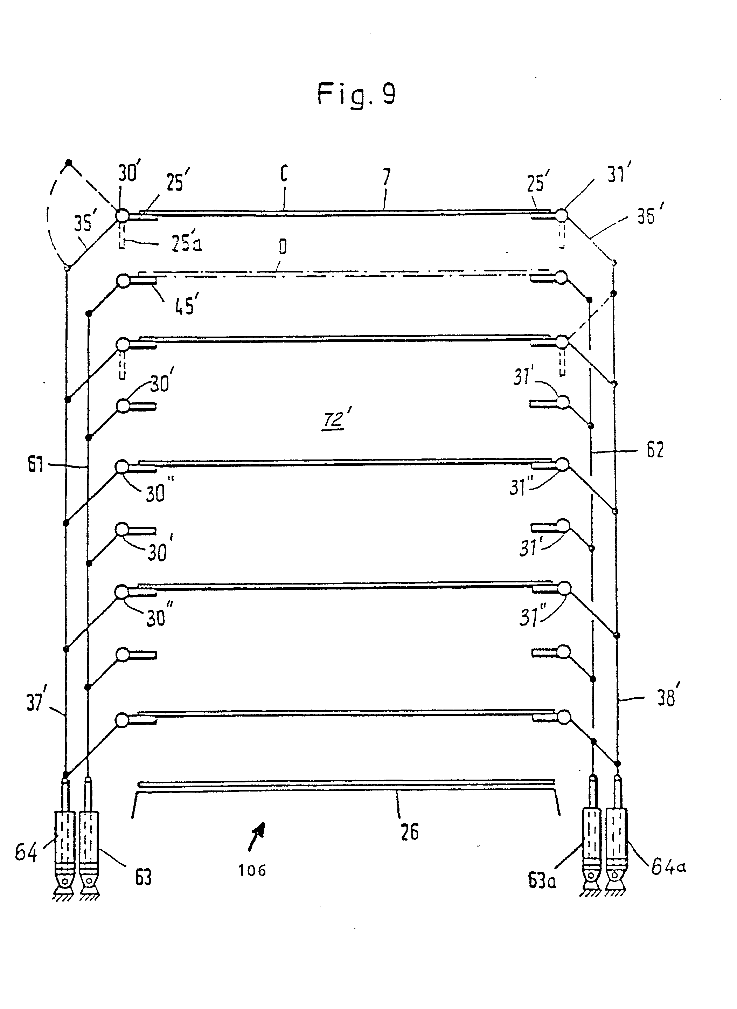

In an alternate embodiment 106, shown in Fig. 9, the upright supports may be placed horizontally instead of upright. In this instance, the upright supports do not carry a set of orthogonal pins, but a set of parallel pins which extend from the supports towards the inside of enclosure 72', defined by the supports. In a similar fashion as before, pivoting levers 35' and 36' connect the horizontal supports 30' and 31' to connecting rods 37' and 38'. In this instance, four pneumatic drives 63 and 64 and 63A and 64A may be used to drive two sets of connecting rods 37' and 61 and 38' and 62. A bottom receiving plate 26' is again made available to receive a plate.

In operation, a plate 7 is first entered in position C in this device. Pneumatic drives 64 and 64A are actuated pushing connecting rods 37' and 38' upwardly, thus lowering supporting pins 25' and dropping plate 7 onto supporting pins 45'. The plate is now in position D shown in phantom lines in the drawing. Pneumatic drives 64 and 64A are actuated again to return pins 25' to their original position. Next, pneumatic drives 63 and 63A are actuated rotating pins 45' and releasing the plate to the next set of pins. Pins 45' are then returned to their original position and the cycle is repeated allowing the plate placed on top of the device to slowly advance towards plate 26' at the bottom.

In the preferred embodiment, the supporting pins may be sufficiently long in order to eliminate plate sagging especially when thin plates are to be used.

While this device has been described as a drying device for printed circuit boards, it must be noted that this is strictly for description purposes and not limiting. Thus for instance, the device may be an enclosure in which a printing plate comprising a support base over which there is coated a photopolymerizable layer is treated with inert gas in order to flush oxygen from the photopolymer layer. This device is useful in any application where holding and individually treating flat plates is important in a process that is normally a continuous process and where limited space is available. And while gravity is disclosed as a convenient means for the plates, other means for moving the plates in an upward direction are also contemplated. Those skilled in the art having the benefits of the teachings of the instant invention, as herein above set forth may effect numerous modifications thereto.

According to Rule 27(9) EPC, the reference signs in the claims shall not be construed as limiting these claims.

## Claims

1. A device for the treatment of planar members that are subjected to the same treatment during a number of cycles, comprising a vertical conveyer (6; 106) with support elements (25;25') on which several members (7) can be supported one above the other with a space between them on both sides; an upper and a lower support plane (9,10) situated one above the other laterally next to the vertical conveyer (6;106), a horizontal conveyer (13) situated in the region of the support planes that is capable of traveling towards the vertical conveyer and returning in every cycle, a first carrier (19) that during the travel movement transports a member from one support plane (9) which is an entry support plane onto support elements of the vertical conveyer, and a second carrier (20;120) that during the return movement transports a member from the support elements of the vertical conveyor onto another support plane (10) which is an exit support plane.

2. The device according to Claim 1 wherein the vertical conveyer (6;106) has a direction of travel from top to bottom.

3. The device according to Claim 2 wherein the vertical conveyer (6;106) is a gravity conveyer whose support elements (25;25') fixed at a certain level can be moved out of the projection of the planar member (7) and again into the projection in each cycle, intermediate supports (45;45') are fixed at a certain level between the support elements and can be moved alternately with the support elements into and out of the projection.

4. The device according to Claim 3 wherein support elements (25) and intermediate supports (45) can be displaced horizontally.

5. The device according to Claim 4 wherein the support elements (25) and intermediate supports (45) are attached staggered on vertical columns (30,31) that can be rotated to and fro through a limited angle by means of a common drive (39).

6. The device according to Claim 5 wherein each column (30,31) is provided with a pivot lever (35,36) with the pivot levers of each side are linked to a common connecting rod (37,38) and the drive (39) has a lifter red (40) joined to both connecting rods via a carrier rod (41).

7. The device according to Claim 3 wherein the support elements (25') and intermediate supports (45') can swivel around horizontal axes (30',31') from their horizontal working position into a vertical rest position.

8. The device according to Claim 7 wherein the support elements (25') and intermediate supports (45') are each provided with a pivot lever (35',36') with pivot levers of the support elements linked to first lifter rods (37',38') and the pivot levers of the intermediate supports are linked to second lifter rods (61,62) of the drive.

9. The device according to anyone of Claims 1 to 8 wherein the support elements (25) and optionally the intermediate supports (45) are attached on at least one side to a common framework (32,33) that can be displaced for the purpose of changing the width of the vertical conveyer (6).

10. The device according to anyone of Claims 1 to 9 wherein the vertical conveyer (6) is situated in a housing (2) having an entry slit (3) and an exit slit (4) at the level of the support planes (9,10).

11. The device according to anyone of Claims 2 to 10 wherein a storage place (11) is provided above the vertical conveyer (6) for a member (7) or a stack of members (12) and the horizontal conveyer (13) has a third carrier (21) that transports a member from the storage place onto the upper support plane during the return movement.

12. The device according to anyone of Claims 1 to 11 wherein the first carrier (19) of the horizontal conveyer (13) is a pusher pad.

13. The device according to anyone of Claims 1 to 12 wherein the second carrier (20,120) of the horizontal conveyer (13) is a spring clip that takes the member (7) between two clamping arms (47,48;147,148).

14. The device according to Claim 13 wherein at least one clamping arm (47,48;147) is bent back diagonally in the direction of the return movement.

15. The device according to Claims 13 or 14 wherein the spring clip (20) is bent from one strip of spring plate.

16. The device according to Claims 13 or 14 wherein the spring clip (120) has one clamping arm (148) attached immovably to the horizontal conveyer (13) and one clamping arm (147) hinged to the horizontal conveyer, which arms are clamped to each other by at least one spring (160).

17. The device according to Claims 12 or 13 wherein a stripper stop (27) is provided in the exit support plane (10) and that the end point of the return movement of the spring clamp (20) is situated behind the stripper stop.

18. The device according to Claim 17 wherein at least one positioning pin (28) with a tapering tip (50) is provided in the exit support plane (10), which pin can reach into a hole in the member (7) that has been stripped by the stripper stop (27) and on the opposite side of the member path there is a press-down device (52) with an elastic pressure element (54) to press the member (7) down.

19. The device according to Claims 17 or 18 wherein the stripper stop (27) and positioning pin (28) can be displaced below the exit support plane (10) by means of lifting devices (57,58).

20. The device according to anyone of Claims 11 to 19 wherein the third carrier (21) of the horizontal conveyer (13) has suction cups (22) to grip the top of the member (7).

21. A device for holding and transporting planar members comprising:
a base,
a plurality of elongated upright supports defining an enclosure, each support pivotally mounted around an axis perpendicular to the base extending through said supports,
each support having at least two orthogonal pins extending there from perpendicular to the axis of the support,
each of said pins located at a point along said axis different than the other,
the pins on the plurality of the upright supports cooperating to define at least a first and a second parallel distinct horizontal planes, and means to rotate the upright supports through an angle from a first position where a first plurality of pins defining the first horizontal plane extend within said enclosure, to a second position where a second plurality of pins defining the second horizontal plane extend within said enclosure, said first plurality of pins no longer extending within said enclosure.

## Revendications

1. Un dispositif pour le traitement de plaquettes ou organes soumis au même traitement pendant un certain nombre de cycles, comprenant un transporteur vertical (6; 106) avec des éléments supports (25; 25'), sur lesquels plusieurs organes (7) peuvent être supportés les uns au-dessus des autres, avec un espace intermédiaire entre eux des deux côtés, des plans-supports supérieur et inférieur (9, 10) étant situés, l'un au-dessus de l'autre, latéralement à proximité du transporteur vertical (6; 106), un transporteur horizontal (13) étant situé dans la zone des plans-supports et pouvant se déplacer en direction du transporteur vertical et revenir à chaque cycle, un premier support (19) qui, pendant le mouvement de déplacement, transporte un organe, depuis un plan-support (9), qui est un plan support d'entrée, jusqu'à des éléments de support du transporteur vertical, et un second support (20; 120) qui, lors du mouvement de retour, transporte un organe depuis les éléments supports du transporteur vertical jusqu'à un autre plan-support (10) qui constitue un plan support de sortie.

2. Le dispositif selon la revendication 1, dans lequel le transporteur vertical (6, 106) présente un sens de déplacement allant de haut en bas.

3. Le dispositif selon la revendication 2, dans lequel le transporteur vertical (6; 106) est un transporteur par gravité, dont les éléments supports (25; 25') fixés à un certain niveau peuvent être déplacés pour être mis à l'écart de la zone de projection de l'organe plan (7) et à nouveau dans cette zone de projection à chaque cycle, des supports intermédiaires (45; 45') étant fixés à un certain niveau, entre les éléments supports et pouvant être déplacés alternativement avec les éléments supports, à l'intérieur et à l'extérieur de la zone de projection.

4. Le dispositif selon la revendication 3, dans lequel les éléments supports (25) et les supports intermédiaires (45) peuvent être déplacés horizontalement.

5. Le dispositif selon la revendication 4, dans lequel les éléments supports (25) et les supports intermédiaires (45) sont fixés en quinconce ou échelonnés sur des colonnes verticales (30, 31) qui peuvent être tournées dans le sens de la longueur et de la largeur, d'un angle limité au moyen d'un système d'entraînement commun (39).

6. Le dispositif selon la revendication 5, dans lequel chaque colonne (30, 31) est pourvue d'un levier pivotant (35, 36), les leviers pivotants de chaque côté étant reliés par une tige commune (37, 38) et le système d'entraînement (39) présentant une tige de levage (40) reliée aux deux tiges de liaison par l'intermédiaire d'une tige support (41).

7. Le dispositif selon la revendication 3, dans lequel les éléments supports (25') et les supports intermédiaires (45') peuvent pivoter autour d'axes horizontaux (30, 31'), pour passer d'une position de travail horizontale à une position de repos verticale.

8. Le dispositif selon la revendication 7, dans lequel les éléments supports (25') et les supports intermédiaires (45') sont chacun pourvus d'un levier de pivotement (35', 36'), les leviers de pivotement des éléments support étant reliés aux premières tiges de levage (37', 38') et les leviers de pivotement des supports intermédiaires étant reliés aux secondes tiges de levage (61, 62) du système d'entraînement.

9. Le dispositif selon l'une quelconque des revendications 1 à 8, dans lequel les éléments supports (25) et, en option, les supports intermédiaires (45) sont fixés, sur un moins un côté, à un châssis commun (32, 33) qui peut être déplacé en vue de modifier la largeur du transporteur vertical (6).

10. Le dispositif selon l'une quelconque des revendications 1 à 9, dans lequel le transporteur vertical (6) est situé dans un carter (2) comportant une fente d'entrée (3) et une fente de sortie (4) au niveau des plans supports (9, 10).

11. Le dispositif selon l'une quelconque des revendications 2 à 10, dans lequel un emplacement de dépôt (11) est prévu au-dessus du transporteur vertical (6), pour un organe (7) ou une pile (12) d'organes, le transporteur horizontal (13) présentant un troisième support (21) qui transporte un organe depuis l'emplacement de dépôt sur le plan de support supérieur pendant le mouvement de retour.

12. Le dispositif selon l'une quelconque des revendications 1 à 11, dans lequel le premier support (19) du transporteur (13) est une plaquette de poussée.

13. Le dispositif selon l'une quelconque des revendications 1 à 12, dans lequel le second support (20, 120) du transporteur horizontal (13) est une pince à ressort qui saisit l'organe (7) entre deux bras de serrage (47, 48; 147, 148).

14. Le dispositif selon la revendication 13, dans lequel au moins un bras de serrage (47, 48; 147) est plié vers l'arrière en diagonale, en direction du déplacement de retour.

15. Le dispositif selon la revendication 13 ou 14, dans lequel la pince à ressort (20) est obtenue par pliage à partir d'une bande d'une plaque ressort.

16. Le dispositif selon la revendication 13 ou 14, dans lequel la pince à ressort (120) présente un bras de serrage (148) fixé immobile au transporteur horizontal (13) et un bras de serrage (147) articulé sur le transporteur horizontal, ces bras étant serrés l'un sur l'autre par au moins un ressort (160).

17. Le dispositif selon la revendication 12 ou 13, dans lequel une butée de séparation (27) est prévue dans le plan support de sortie (10) et de façon que le point d'extrémité du déplacement de retour de la pince à ressort (20) soit situé derrière la butée de séparation.

18. Le dispositif selon la revendication 17, dans lequel au moins une tige de positionnement (28) portant un embout conique (50) est prévue dans le plan support de sortie (10), laquelle tige peut pénétrer dans un trou ménagé dans l'organe (7) qui a été séparé par la butée de séparation (27) et, sur la face opposée de la trajectoire de l'organe, est situé un dispositif de pressage vers le bas (52), avec un élément de pression élastique (54) pour comprimer vers le bas l'organe (7).

19. Le dispositif selon la revendication 17 ou 18, dans lequel la butée de séparation (27) et la tige de positionnement (28) peuvent être déplacées au-dessous du plan support de sortie (10), au moyen de dispositifs de levage (57, 58).

20. Un dispositif selon l'une quelconque des revendications 11 à 19, dans lequel le troisième support (21) du transporteur horizontal (13) présente des ventouses (22) pour saisir le dessus de l'organe (7).

21. Un dispositif pour maintenir et transporter des organes plans, comprenant:
    - une base,
    - une pluralité de supports verticaux allongés définissant une enceinte, chaque support étant monté pivotant autour d'un axe perpendiculaire à la base et s'étendant à travers lesdits supports,
    - chaque support présentant au moins deux tiges perpendiculaires en s'en éloignant perpendiculairement à l'axe du support,
    - chacune desdites tiges étant située sur l'axe en des points différents les uns des autres,
    - les tiges de la pluralité des supports verticaux coopérant pour définir au moins des premier et second plan horizontaux parallèles distincts, et
    - des moyens pour faire tourner les supports verticaux d'un certain angle à partir d'une première position dans laquelle une première pluralité de tiges définissant le premier plan horizontal s'étend à l'intérieur de ladite enceinte, jusqu'à une seconde position dans laquelle une seconde pluralité de tiges définissant le second plan horizontal s'étend à l'intérieur de ladite enceinte, ladite première pluralité de tiges ne s'étendant alors plus à l'intérieur de ladite enceinte.

## Ansprüche

1. Vorrichtung zur Behandlung ebener Bauteile, die im Laufe einer Anzahl von Cyclen der gleichen Behandlung unterworfen werden, umfassend
    einen Vertikal-Förderer (6; 106) mit Träger-Elementen (25; 25'), auf denen mehrere Bauteile (7) übereinander mit einem Zwischenraum zwischen ihnen auf beiden Seiten gehalten werden werden können;
    eine obere und eine untere Träger-Ebene (9, 10), die übereinander lateral gleich neben dem vertikalen Förderer (6; 106) angeordnet sind;
    einen im Bereich der Trägerebenen angeordneten Horizontal-Förderer (13), der befähigt ist, in jedem Cyclus eine Arbeitsbewegung zu dem Vertikal-Förderer hin auszuführen und zurückzukehren,
    einen ersten Träger (19), der während der Arbeitsbewegung ein Bauteil von einer Träger-Ebene (9), die eine Eingangs-Träger-Ebene ist, auf Träger-Elemente des Vertikal-Förderers transportiert, und
    einen zweiten Träger (20; 120), der während der Rückkehr-Bewegung ein Bauteil von den Träger-Elementen des Vertikal-Förderers auf eine andere Träger-Ebene (10), die eine Ausgangs-Träger-Ebene ist, transportiert.

2. Vorrichtung nach Anspruch 1, worin der Vertikal-Förderer (6; 106) eine Richtung der Arbeitsbewegung von oben nach unten hat.

3. Vorrichtung nach Anspruch 2, worin der Vertikal-Förderer (6; 106) ein Schwerkraftförderer ist, dessen auf einem bestimmten Niveau befestigten Träger-Elemente (25; 25') in jedem Cyclus aus dem Vorsprung des ebenen Bauteils (7) heraus und wieder in diesen Vorsprung hineinbewegt werden können, Zwischen-Träger (45; 45') auf einem bestimmten Niveau zwischen den Träger-Elementen befestigt sind und alternierend mit den Träger-Elementen in den Vorsprung hinein und aus dem Vorsprung heraus bewegt werden können.

4. Vorrichtung nach Anspruch 3, worin Träger-Elemente (25) und Zwischen-Träger (45) horizontal verschoben werden können.

5. Vorrichtung nach Anspruch 4, worin die Träger-Elemente (25) und Zwischen-Träger (45) versetzt angeordnet auf vertikalen Säulen (30, 31) befestigt sind, die mittels eines gemeinsamen Antriebs (39) um einen begrenzten Winkel hin- und herbewegt werden können.

6. Vorrichtung nach Anspruch 5, worin jede Säule (30, 31) mit einem drehbar gelagerten Hebel (35, 36) versehen ist, wobei die drehbar gelagerten Hebel (35, 36) jeder Seite mit einem gemeinsamen Verbindungsstab (37, 38) gekoppelt sind und der Antrieb (39) eine Hubstange (40) aufweist, die mit den beiden Verbindungsstäben mittels einer Mitnehmerstange (41) verbunden sind.

7. Vorrichtung nach Anspruch 3, worin Träger-Elemente (25') und Zwischen-Träger (45') um horizontale Achsen (30', 31') aus ihrer horizontalen Arbeitsposition Schwenkbewegungen in eine vertikale Ruheposition durchführen können.

8. Vorrichtung nach Anspruch 7, worin die Träger-Elemente (25') und Zwischen-Träger (45') jeweils mit einem drehbar gelagerten Hebel (35', 36') versehen sind, wobei die drehbar gelagerten Hebel der Träger-Elemente mit ersten Hubstangen (37', 38') gekoppelt sind und die drehbar gelagerten Hebel der Zwischen-Träger mit zweiten Hubstangen (61, 62) des Antriebes gekoppelt sind.

9. Vorrichtung nach irgendeinem der Ansprüche 1 bis 8, worin die Träger-Elemente (25) und gegebenenfalls die Zwischen-Träger (45) auf wenigstens einer Seite an einem gemeinsamen Rahmengestell (32, 33) befestigt sind, das zum Zweck der Änderung der Breite des Vertikal-Förderers (6) verschoben ist.

10. Vorrichtung nach irgendeinem der Ansprüche 1 bis 9, worin der Vertikal-Förderer (6) in einem Gehäuse (2) mit einem Eingangsspalt (3) und einem Ausgangsspalt (4) auf den Niveaus der Träger-Ebenen (9,10) angeordnet ist.

11. Vorrichtung nach irgendeinem der Ansprüche 2 bis 10, worin ein Abstellplatz (11) oberhalb des Vertikal-Förderers (6) für ein Bauteil (7) oder einen Stapel von Bauteilen (12) vorgesehen ist und der Horizontal-Förderer (13) einen dritten Träger (21) aufweist, der während der Rückkehrbewegung ein Bauteil von dem Abstellplatz auf die obere Träger-Ebene transportiert.

12. Vorrichtung nach irgendeinem der Ansprüche 1 bis 11, worin der erste Träger (19) des Horizontal-Förderers (13) ein Vorschubpolster ist.

13. Vorrichtung nach irgendeinem der Ansprüche 1 bis 12, worin der zweite Träger (20, 120) des Horizontal-Förderers (13) eine Federklammer (20) ist, die das Bauteil (7) zwischen zwei Klammerschenkeln (47, 48; 147, 148) aufnimmt.

14. Vorrichtung nach Anspruch 13, worin wenigstens ein Klammerschenkel (47, 48; 147, 148) diagonal in Richtung der Rückkehrbewegung gebogen ist.

15. Vorrichtung nach den Ansprüchen 13 oder 14, worin die Federklammer (20) aus einem Streifen einer Federplatte gebogen ist.

16. Vorrichtung nach den Ansprüchen 13 oder 14, worin die Federklammer (120) einen unverrückbar an dem Horizontal-Förderer (13) befestigten Klammerschenkel (148) und einen über ein Scharnier an dem Horizontal-Förderer befestigten Klammerschenkel (147) besitzt, wobei die Arme mittels wenigstens einer Feder (160) aneinandergeklammert sind.

17. Vorrichtung nach den Ansprüchen 12 oder 13, worin eine Abstreifsperre (27) auf der Ausgangs-Träger-Ebene (10) angebracht ist und der Endpunkt der Rückkehrbewegung der Federklammer (20) hinter der Abstreifsperre liegt.

18. Vorrichtung nach Anspruch 17, worin wenigstens ein Positionierstift (28) mit einer sich verjüngenden Spitze (50) auf der Ausgangs-Träger-Ebene (10) angebracht ist, der in ein Loch in dem Bauteil (7) hineinreichen kann, das von der Abstreifsperre (27) abgestreift worden ist, und auf der anderen Seite eine Vorrichtung zum Hinunterdrücken mit einem elastischen Druckelement (54) vorhanden ist, um das Bauteil (7) hinunterzudrücken.

19. Vorrichtung nach den Ansprüchen 17 oder 18, worin die Abstreifsperre (27) und der Positionierstift (28) mit Hilfe von Hubvorrichtungen (57, 58) unter der Ausgangs-Träger-Ebene (10) verschoben werden können.

20. Vorrichtung nach irgendeinem der Ansprüche 11 bis 19, worin der dritte Träger (21 des Horizontal-Förderers (13) Saugnäpfe (22) aufweist, um die Oberseite des Bauteils (7) zu greifen.

21. Vorrichtung zum Halten und Transportieren ebener Bauteile, umfassend
eine Unterlage,
eine Mehrzahl aufrechter Träger, die eine Umhüllung begrenzen, wobei jeder Träger um eine zu der Unterlage senkrechte und durch die betreffenden Träger verlaufende Achse drehbar befestigt ist,

wobei jeder Träger wenigstens zwei auf ihm senkrecht stehende Stifte aufweist, die sich von ihm senkrecht zu der Achse des Trägers erstrecken,

wobei jeder der genannten Stifte an einem Punkt längs der Achse angeordnet ist, der von dem des anderen verschieden ist,

wobei die Stifte auf der Mehrzahl der aufrechten Träger dahingehend zusammenwirken, daß sie wenigstens eine erste und eine von dieser unterschiedene zweite horizontale Ebene definieren, und

Mittel, um die aufrechten Träger um einen Winkel aus einer ersten Position, in der eine erste Mehrzahl von die erste horizontale Ebene innerhalb der Umhüllung definierenden Stiften sich erstrecken, in eine zweite Position, in der eine zweite Mehrzahl von die zweite horizontale Ebene innerhalb der Umhüllung definierenden Stiften sich erstrecken, zu drehen, wobei die erste Mehrzahl von Stiften sich nicht länger im Inneren der Umhüllung erstreckt.

# Fig.1

EP 0 165 561 B1

EP 0 165 561 B1

Fig.2

Fig.3

Fig.4

Fig.5

12

Fig. 6

Fig. 7

Fig. 8

13

# Fig. 9